# EUROPÄISCHE PATENTSCHRIFT

(11) **EP 2 697 830 B1**
(45) Veröffentlichungstag und Bekanntmachung des Hinweises auf die Patenterteilung: **21.01.2015**
(21) Anmeldenummer: 12715825.1
(22) Anmeldetag: 29.03.2012
(51) Int. Cl.: H01L 29/45, H01L 29/78, H01L 29/16

(54) **HALBLEITERBAUELEMENT**
SEMICONDUCTOR COMPONENT
COMPOSANT SEMI-CONDUCTEUR

(30) Priorität: 13.04.2011 DE 102011016900
(43) Veröffentlichungstag der Anmeldung: 19.02.2014
(73) Patentinhaber: Friedrich-Alexander-Universität Erlangen-Nürnberg, 91054 Erlangen (DE)
(72) Erfinder: WEBER, Heiko, B., 91052 Erlangen (DE); KRIEGER, Michael, 90552 Röthenbach (DE); HERTEL, Stefan, 91154 Roth (DE); KRACH, Florian, 90587 Veitsbronn (DE); JOBST, Johannes, 90766 Fürth (DE); WALDMANN, Daniel, 67245 Lambsheim (DE)
(74) Vertreter: FDST Patentanwälte
(86) Internationale Anmeldenummer: PCT/EP2012/001383
(87) Internationale Veröffentlichungsnummer: WO 2012/139710

(56) Entgegenhaltungen:
- CN-B- 101 404 322
- US-A1- 2009 236 609
- JÃ 1/4 RGEN RISTEIN ET AL: "Characteristics of solution gated field effect transistors on the basis of epitaxial graphene on silicon carbide;Solution gated field effect transistor on epitaxial graphene/SiC", JOURNAL OF PHYSICS D. APPLIED PHYSICS, IOP PUBLISHING, BRISTOL, GB, Bd. 43, Nr. 34, 12. August 2010 (2010-08-12), Seite 345303, XP020196779, ISSN: 0022-3727, DOI: 10.1088/0022-3727/43/34/345303
- F. KRACH ET AL: "A switch for epitaxial graphene electronics: Utilizing the silicon carbide substrate as transistor channel", APPLIED PHYSICS LETTERS, Bd. 100, Nr. 12, 1. Januar 2012 (2012-01-01), Seite 122102, XP55030241, ISSN: 0003-6951, DOI: 10.1063/1.3695157

## Beschreibung

Die Erfindung betrifft ein Halbleiterbauelement mit einem Halbleitersubstrat aus Siliziumkarbid und mit darauf aufgebrachten, getrennten Elektroden.

Ein solches Halbleiterbauelement auf Basis von Siliziumkarbid ist beispielsweise aus der US 3,254,280 bekannt. Das dort gezeigte Halbleiterbauelement ist als ein Sperrschicht-Feldeffekttransistor (Sperrschicht-FET) aufgebaut. Auf dem Halbleitersubstrat befinden sich eine Source-, eine Gate- und eine Drain-Elektrode. Der Stromkanal zwischen der Source- und der Drain-Elektrode ist durch das Halbleitersubstrat gebildet. Unter der Gate-Elektrode zeigt das Siliziumkarbid durch Dotierung einen vertikalen p-n-p-Übergang. Durch Anlegen einer Gate-Spannung ist die Leitfähigkeit des Stromkanals steuerbar.

Generell eignet sich Siliziumkarbid aufgrund der vergleichsweise hohen Bandlücke von etwa 3 eV zur Schaltung und zur Steuerung hoher Ströme und hoher Spannungen. Die gegenwärtigen technischen Anwendungskonzepte basieren auf dem Prinzip eines MOSFET's, eines JFET's oder eines Bipolartransistors. Zur Realisierung derartiger Bauelemente sind n- und p-leitende Bereiche erforderlich, die durch entsprechendes Dotieren des Siliziumkarbids erzeugt sind.

Aufgabe der Erfindung ist es, ein neuartiges Halbleiterbauelement auf der Basis von Siliziumkarbid anzugeben, welches vielfältig einsetzbar und einfach herzustellen ist.

Diese Aufgabe wird erfindungsgemäß gelöst durch ein Halbleiterbauelement mit einem Halbleitersubstrat aus Siliziumkarbid, wobei auf dem Siliziumkarbid getrennte Elektroden, die jeweils wenigstens eine Monolage, epitaktisches Graphen auf Siliziumkarbid umfassen, aufgebracht sind, so dass ein Stromkanal zwischen den Elektroden durch das Halbleitersubstrat gebildet ist.

Graphen als eine Monolage des Graphits ist erst seit wenigen Jahren bekannt und zeigt außerordentlich gute elektrische Eigenschaften wie eine sehr hohe Ladungsträgermobilität und eine sehr hohe Stromtragfähigkeit. Die Erfindung geht in einem ersten Schritt von der Überlegung aus, die hervorragenden elektrischen Eigenschaften des Graphens zur Konstruktion eines neuartigen Halbleiterbauelements mit verbesserten Eigenschaften heranzuziehen.

Bisherige Überlegungen zum Einsatz von Graphen für Halbleiterbauelemente basieren dabei mehrheitlich auf dem Feldeffektprinzip. In einlagigem Graphen ist jedoch aufgrund der fehlenden Energielücke (Graphen ist kein Halbleiter) kein hohes on / off-Verhältnis, also der Signalhub zwischen eingeschaltetem und ausgeschaltetem Zustand, erzielbar. Zu diesem Problem ist aus der DE 10 2008 042 323 A1 ein Graphen-Bauelement nach dem Feldeffektprinzip bekannt, wobei der durch Graphen gebildete Stromkanal zwischen einer Source- und einer Drain-Elektrode durch Anlegen einer Gate-Spannung gesteuert wird. Der dort erzielbare, vergleichsweise hohe Signalhub beruht auf einer chemischen Modifikation des Graphens durch den Schaltvorgang. Andererseits wird entsprechend der US 2009/0140801 A1 der Stromkanal durch einen engen Draht aus Graphen zwischen einer Source- und einer Drain-Elektrode gebildet. Durch den engen Draht kommt es zu einer Quantisierung der für die Ladungsträger erlaubten Energieniveaus, wodurch eine Energielücke im Graphen erzwungen ist.

Allen diesen bisherigen Konzepten ist gemeinsam, Graphen als solches als Material für den steuerbaren Stromkanal zu verwenden, um so dessen hervorragende elektrische Eigenschaften ideal für das zu schaffende Bauelement zu nutzen.

Weiter wird in der US 2009/0236609 A1 ein Feldeffekttransistor mit einem isolierten Gatter und epitaktischen Graphen-Elektroden auf einem Substrat aus Silizumkarbid vorgeschlagen. Die Graphen-Elektroden sind hierbei durch Graphenoxid getrennt. Auch ist aus der CN 101 404 322 B ein Feldeffekttransistor mit Graphen-Elektroden bekannt. Die Elektroden sind dabei durch einen Kanal aus organischen Molekülen, hochvernetzten Polymeren oder halbleitenden Polymer-Materialien getrennt.

In einem zweiten Schritt geht die Erfindung nun überraschend von der Überlegung aus, den bislang eingeschlagenen Weg der Fachwelt zum Einsatz von Graphen für elektronische Bauelemente zu verlassen. Die bislang konzipierten Bauelemente sind aufwendig herstellbar und bezüglich ihrer Strom- und Schalteigenschaften nur in begrenztem Umfang einsetzbar. Die Erfindung beschreitet vielmehr den Weg, Graphen als Elektrodenmaterial zur Strominjektion zu verwenden, während der steuerbare Stromkanal durch das darunterliegende Halbleitersubstrat gebildet ist. Dazu sind die Elektroden voneinander getrennt auf das Halbleitersubstrat aufgebracht. Eine Materialbrücke aus Graphen zwischen den Elektroden ist nicht vorhanden.

Zu dem Schritt, Graphen als Elektrodenmaterial auf Siliziumkarbid einzusetzen, gelangt die Erfindung weiter durch die Erkenntnis darüber, dass sich Graphen vergleichsweise einfach durch eine thermische Zersetzung von Siliziumkarbid-Oberflächen herstellen lässt. Bei Temperaturen oberhalb der Sublimationsschwelle von Silizium in Siliziumkarbid (beispielsweise in einer Argon-Atmosphäre bei etwa 1.700 °C) sublimiert das Silizium aufgrund seines im Vergleich zu Kohlenstoff höheren Dampfdrucks. Auf der Oberfläche des Siliziumkarbids bilden sich hierbei Monolagen epitaktischen Graphens, ohne dass es einer aufwendigen Prozesssteuerung bedarf. Die Erzeugung epitaktischen Graphens auf Siliziumkarbid ist beispielsweise aus Nature Materials, Konstantin V. Emtsev, "Towards wafer-size Graphene Layers by Atmospheric Pressure Graphitization of Silicon Carbide", Vol. 8, März 2009, Seiten 203 bis 207, bekannt. Beispielsweise kann epitaktisches Graphen auf der hexagonalen (0001)-Oberfläche des 6 H-Polytyps von Siliziumkarbid hergestellt werden. Jedoch sind andere Polytypen des Siliziumkarbids und andere Kristallorientierungen ebenfalls verwendbar, um epitaktisches Graphen auf der Oberfläche zu züchten. Insbesondere ist auch ein multikristallines Siliziumkarbid eingesetzt. Da ausgedehnte Defekte innerhalb des Bauelementes, wie insbesondere Korngrenzen, Leckströme erhöhen, empfiehlt es sich gegebenenfalls, die Korngrößen in multikritallinem Siliziumkarbid nicht zu klein zu wählen.

Entsprechend eigener Untersuchungen wurden für epitaktisches Graphen auf Siliziumkarbid Ladungsträgermobilitäten von 29.000 cm²/ Vs und Ladungsträgerdichten von 1*10¹³ cm⁻² beobachtet, wobei diese Eigenschaften tolerant gegenüber Substratunregelmäßigkeiten sind. Ebenfalls wurde durch eigene Untersuchungen eine Stromtragfähigkeit des epitaktischen Graphens von etwa j = 4 mA / µm beobachtet. Die Schichtleitfähigkeit lässt sich durch Mehrlagen-Graphen bis hin zu graphitischen Schichten verbessern. Darüber hinaus haben weitere eigene Untersuchungen gezeigt, dass Graphen-Elektroden auf Siliziumkarbid eine niedrige Injektionsbarriere aufweisen.

In Kenntnis der eigenen Untersuchungen wird somit ein Halbleiterbauelement geschaffen, welches in idealer Weise die physikalischen und elektrischen Eigenschaften einer epitaktischen Grenzfläche zwischen Siliziumkarbid und der ersten Graphenschicht umfassend nutzt. Während herkömmliche Graphen-Bauelemente, bei denen Graphen einen steuerbaren Stromkanal bildet, durch hohe Material- und Prozessanforderungen teuer sind, kann das hier vorgeschlagene Halbleiterbauelement mit Elektroden aus Graphen aus Siliziumkarbid vergleichsweise günstig durch eine thermische Zersetzung der Substratoberfläche als solcher hergestellt werden. Die prozesstechnischen Anforderungen sind gegenüber dem Stand der Technik deutlich verringert. Die Verwendung epitaktischen Graphens auf Siliziumkarbid ermöglicht unter anderem Bauformen ohne die Gefahr einer Feldüberhöhung an den Kanten.

Verglichen mit bisherigen Transistoren auf Basis von Siliziumkarbid stellt das hier vorgeschlagene Bauelement verringerte Anforderungen an die Qualität der verwendenden Siliziumkarbid-Kristalle und weist bei einer wesentlich vereinfachten Prozessierung gleichzeitig eine hohe potenzielle Stromtragfähigkeit und Spannungsfestigkeit auf. Darüber hinaus ist ohne Probleme eine Integration mehrerer Bauelemente auf einem Chip möglich. Aufgrund der elektrischen und physikalischen Eigenschaften epitaktischen Graphens ist im Vergleich zu den Konzepten mit reinem Graphen ein wesentlich größeres und technologisch sinnvolleres On / Off-Verhältnis erzielbar.

Unter epitaktischem Graphen wird hierbei die auf einer Oberfläche des Siliziumkarbids epitaktisch hergestellte erste Graphen-Monolage verstanden. Die Grenzfläche zwischen dem epitaktischen Graphen und dem Siliziumkarbid ist maßgeblich für die physikalischen und elektrischen Eigenschaften des Bauelements. Von der Erfindung sind dabei nicht nur Elektroden mit einer einzigen Monolage epitaktischen Graphens umfasst. Vielmehr sind auch Elektroden umfasst, die mehrere Monolagen an Graphen übereinander bis hin zu graphitischem Material umfassen. Insbesondere wird die Schichtleitfähigkeit der Elektroden hierdurch verbessert. Den Elektroden gemäß der Erfindung ist jedoch gemeinsam, dass die Grenzfläche zwischen der Elektrode und dem Siliziumkarbid durch eine Monolage epitaktischen Graphens gebildet ist.

Durch eine Anpassung der Geometrie und der Dotierungsverhältnisse im Siliziumkarbid, sowie durch die Wahl der Graphen- / Graphit-Schichtdicke lassen sich die elektrischen Eigenschaften des angegebenen Halbleiterbauelements in einem weiten Bereich an verschiedene Bauelementanforderungen anpassen. So ist grundsätzlich eine Skalierung vom Nanometer- bis in den Zentimeter-Bereich der Kanallänge zwischen den Elektroden möglich. Bezüglich der Herstellung ist eine parallele Prozessierung auf einem Wafer und eine mögliche Herstellung integrierter Schaltkreise gegeben. Die Prozessierung kann CMOS kompatibel geführt sein.

Da die Graphen-Elektroden ultraflach ausgebildet sind, kommt es zu keiner Kanten-Feldüberhöhung, so dass bezüglich möglicher Steuer- bzw. Gate-Elektroden flache Gate-Stapel eingesetzt werden können, um die notwendige elektrische Isolierung der Gate-Elektrode zur Source- oder Drain-Elektrode zu erzielen. Das Herstellungsverfahren ist grundsätzlich unkritisch gegenüber Allignment-Ungenauigkeiten. Das angegebene Halbleiterbauelement ist potenziell ohne Lithographie herstellbar.

Das angegebene Bauelement ist unkritisch gegenüber ausgedehnten Kristalldefekten im Siliziumkarbid. Daneben hat es sich herausgestellt, dass Graphen eine Diffusionssperre bildet, die das Eindringen von Defekten in das Halbleitersubstrat unterdrückt.

Das angegebene Halbleiterbauelement auf Basis des epitaktischen Systems Graphen auf Siliziumkarbid nutzt zusammengefasst als positive Eigenschaften die niedrige Injektionsbarriere zwischen Graphen und Siliziumkarbid, die hohe Stromtragfähigkeit von Graphen und Siliziumkarbid, die hohe Durchbruchfeldstärke von Siliziumkarbid, die hohe Volumenladungsträgerbeweglichkeit von Siliziumkarbid, die hohe Ladungsträgerbeweglichkeit von Graphen sowie die chemische, mechanische und thermische Robustheit des eingesetzten Materialverbundes.

Bevorzugt sind die getrennten Elektroden durch eine, wenigsten die eine Lage epitaktisches Graphen umfassende Schicht gebildet, die zwischen den Elektroden unterbrochen ist. Mit anderen Worten wird die Schicht epitaktischen Graphens durch thermisches Zersetzen des Siliziumkarbids gebildet. Anschließend wird diese Schicht zur Ausbildung der getrennten Elektroden unterbrochen. Dies kann beispielsweise mechanisch oder elektrochemisch, insbesondere durch Plasmaätzen, vorgenommen werden. Zwischen den Elektroden ist die Oberfläche des Siliziumkarbids freigelegt.

Zur Ausgestaltung eines elektronischen Schaltelements sind in einer bevorzugten Ausgestaltung als Elektroden auf dem Halbleitersubstrat eine Source-Elektrode und eine hiervon getrennte Drain-Elektrode aufgebracht, wobei zwischen der Source-Elektrode und der Drain-Elektrode eine elektrisch isolierte Gate-Elektrode angeordnet ist. Wie bereits ausgeführt, sind durch die ultraflachen Graphen-Elektroden Feldüberhöhungen an den Kanten vermieden. Zur Isolierung der Gate-Elektrode zur Source- und / oder Drain-Elektrode genügt insofern ein vergleichsweiße niedriger Gate-Stapel, so dass das Halbleiterbauelement insgesamt flach gehalten ist. Zweckmäßigerweise ist zur Beabstandung der Gate-Elektrode dem Siliziumkarbid zwischen Source- und Drain-Elektrode ein Dielektrikum aufgesetzt. Die Gate-Elektrode kann hierbei insbesondere aus einem entsprechend geeigneten Metall bestehen.

In einer alternativen Ausgestaltung ist die Gate-Elektrode durch ein Elektrolyt ausgebildet. Dabei übernimmt eine eintauchende Elektrode die Funktion der Kontaktierung. Ein elektrolytisches Medium wirkt als ein Gate-Kondensator. Insbesondere ist als ein elektrolytisches Medium eine ionische Flüssigkeit auf dem Halbleitersubstrat aufgebracht. Zum elektrischen Anschluss taucht hierbei beispielsweise eine metallische Spitze in die ionische Flüssigkeit ein. Wird eine Spannung angelegt, so führt dies in der ionischen Flüssigkeit zur Ausbildung einer sogenannten Helmholtz- bzw. Stem-Doppelschicht. Das Halbleitersubstrat unterhalb der Gate-Elektrode sieht einen Ladungswechsel.

In einer bevorzugten Weiterbildung des Halbleiterbauelements weist das Halbleitersubstrat ein vertikales Dotierprofil auf. Um den Stromkanal durch das Halbleitersubstrat durch Anlegen einer Gate-Spannung steuerbar zu machen, sollte er möglichst oberflächennah im Halbleitersubstrat verlaufen. Eine Ausdehnung des Stromkanals in den Bulk des Halbleitersubstrats hinein wird jedoch durch ein vertikales Dotierprofil vermieden. Dazu kann beispielsweise in vertikaler Richtung, also senkrecht zur Oberfläche des Halbleitersubstrats und zu den darauf aufgebrachten Graphen-Elektroden, durch eine entsprechende Dotierung des Siliziumkarbids ein Übergang oder eine Abfolge zwischen n- und p-leitenden Bereichen erzeugt werden. Durch die an einem solchen n-p-Übergang im Halbleitersubstrat auftretende Verarmungszone an Ladungsträgern ist der Stromkanal im Wesentlichen auf eine horizontale Richtung begrenzbar. Durch Anlegen einer Gate-Spannung an den Bereich zwischen den Elektroden ist über eine Beeinflussung der Verarmungszone oder durch eine Ladungsträgerinfluenzierung eine Steuerung des Stromkanals ermöglicht. Zum Aufbau des angegebenen Halbleiterbauelements ist ein horizontales Dotierprofil im Halbleitersubstrat nicht erforderlich. Prozesstechnisch bringt die Erstellung lediglich eines vertikalen Dotierprofils im Siliziumkarbid weitere kostentechnische Vorteile. Die Leitfähigkeit des Stromkanals ist durch die Spannung an der Gate-Elektrode steuerbar.

Eine n-Dotierung des Siliziumkarbids erfolgt bevorzugt mittels Stickstoff oder Phosphor. Zu einer p-Dotierung des Siliziumkarbids wird bevorzugt Aluminium, Bor oder Gallium herangezogen.

Bevorzugt ist das Siliziumkarbid in einem ersten Bereich, der den Elektroden zugewandt ist, n-dotiert, und weist in einem zweiten Bereich, der den Elektroden abgewandt ist, eine p-Dotierung auf. Dabei ist berücksichtigt, dass epitaktisches Graphen gegenüber n-dotiertem Siliziumkarbid die geringste Injektionsbarriere des betrachteten Systems besitzt. Die Grenzfläche aus epitaktischem Graphen und n-leitendem Siliziumkarbid weist den niedrigst möglichen Kontaktwiderstand auf. Dabei hat sich zusätzlich gezeigt, dass durch eine an den Elektroden lokal erhöhte Dotierung die Injektion der Ladungsträger weiter verbessert werden kann.

Zweckmäßigerweise sind die Dotierkonzentration und die vertikale Dicke des ersten, den Elektroden benachbarten Bereiches derart gewählt, dass sich eine am n-p-Übergang entlang der Dotiergrenze ausbildende Verarmungszone gegebenenfalls durch Anlegen einer äußeren elektrischen Spannung in den ersten Bereich hinein bis zur Oberfläche des Halbleitersubstrats erstreckt. Dabei ist bevorzugt die Dotierung des ersten Bereiches geringer gewählt als die Dotierung des zweiten Bereiches. Da sich die Dicke der sich an einem n-p-Übergang ausbildenden Raumladungszone oder Verarmungszone umgekehrt zur Konzentration der Akzeptoren oder Donatoren bzw. allgemein der Dotierkonzentration verhält, erstreckt sich durch diese Maßnahme die Raumladungszone ausgehend von der Dotiergrenze weiter in Richtung zu den Elektroden als von diesen weg.

Erstreckt sich im spannungsfreien Zustand die Raumladungszone bis an die Oberfläche des Halbleitersubstrats bzw. bis zu den Elektroden, so resultiert ein sogenanntes "normally-off"-Bauelement. Im spannungsfreien Zustand ist die Leitfähigkeit im Halbleitersubstrat oberflächennah zwischen den Elektroden aufgrund der Ladungsträgerverarmung in der Raumladungszone minimiert. Mit anderen Worten fließt zwischen den Elektroden durch das Halbleitersubstrat im spannungsfreien Zustand kein signifikanter Strom. Das Halbleiterbauelement ist gesperrt. Wird andererseits über eine Gate-Elektrode eine Spannung geeigneter Polarität angelegt, so wird über diese Spannung die Ausdehnung der Raumladungszone zurückgedrängt. Unterhalb der Gate-Elektrode werden im Halbleitersubstrat Ladungsträger influenziert. Über diese Ladungsträger ist im dotierten Halbleitersubstrat ein leitfähiger Stromkanal zwischen den Elektroden gebildet.

Erstreckt sich andererseits im spannungsfreien Zustand die Raumladungszone ausgehend von der Dotiergrenze bzw. dem n-p-Übergang nicht bis zu den Graphen-Elektroden, so resultiert ein "normally-on"-Bauelement. Liegt nämlich keine Spannung an, so ist durch den n- oder p-leitenden Bereich des Halbleitersubstrats unterhalb der Graphen-Elektroden ein leitfähiger Stromkanal im Halbleitersubstrat gebildet. Durch Anlegen einer Spannung an eine Gate-Elektrode zwischen den Graphen-Elektroden werden Ladungsträger aus der an sich leitfähigen Schicht verdrängt. Die Leitfähigkeit des Stromkanals zwischen den Elektroden wird herabgesetzt. Das Halbleiterbauelement sperrt.

Zweckmäßigerweise betragen die Dotierkonzentrationen im ersten Bereich zwischen 10¹¹ bis 10²⁰ Atomen pro cm³ bei zugeordneten vertikalen Dicken zwischen 150 µm und 5 nm. Dabei gilt die niedrige Dotierkonzentration für eine größere Dicke und die hohe Dotierkonzentration für eine geringere Dicke. Je nach gewünschter Dimensionierung des Halbleiterbauelements ist es möglich, die Dotierkonzentration und die Dicke des ersten, den Elektroden benachbarten dotierten Bereiches aufeinander abzustimmen, so dass die Tiefe des Stromkanals entsprechend konfiguriert ist. Besonders bevorzugt betragen die Dotierkonzentrationen im ersten Bereich zwischen 10¹³ bis 10¹⁸ Atomen pro cm³ bei zugeordneten vertikalen Dicken zwischen 15 µm und 10 nm

In einer weiter vorteilhaften Ausgestaltung des Halbleiterbauelements ist eine Backgate-Elektrode umfasst, die elektrisch leitend mit dem zweiten Bereich verbunden ist. Die Backgate-Elektrode ist beispielsweise unmittelbar auf der Rückseite oder seitlich auf der Vorderseite des Halbleitersubstrats angeordnet und mit dem zweiten Bereich elektrisch kontaktiert. Insbesondere bei einem vertikalen Dotierprofil des Halbleitersubstrats beispielsweise entsprechend eines vertikalen n-p-Übergangs kann durch Anlegen einer Spannung an die Backgate-Elektrode die Ausdehnung der Raumladungszone bzw. Verarmungszone an dem n-p-Übergang gesteuert werden. Somit ist es möglich, ein einziges Halbleiterbauelement zu schaffen, welches zwischen einem "normally-off"- und einem "normally-on"-Zustand in operandi durch Wahl einer geeigneten Backgate-Spannung umgeschaltet werden kann. Dies bietet interessante schaltungstechnische Aspekte, die bislang mit üblichen Halbleiterbauelementen nicht realisiert werden können.

In einer anderen, ebenfalls vorteilhaften Ausgestaltung ist ein vertikales Dotierprofil im Halbleitersubstrat dadurch realisiert, dass das Silizikumkarbid in einem ersten, den Elektroden benachbarten Bereich n dotiert ist. In einem zweiten hierauf folgenden, den Elektroden abgewandten Bereich ist ein semiisolierendes Siliziumkarbid vorhanden. Da Siliziumkarbid aufgrund des Vorhandenseins von Luftstickstoff grundsätzlich n-leitend ist, wird ein semiisolierendes Siliziumkarbid beispielsweise dadurch hergestellt, dass es mit Vanadium dotiert ist. Durch eine Vanadium-Dotierung werden die aufgrund der unvermeidbaren n-Dotierung mittels Luftstickstoff vorhandenen Elektronen als Majoritätsladungsträger auf ein energetisch niedrigeres Energieniveau abgefangen. Dadurch tragen diese Elektroden nicht mehr zur Leitfähigkeit bei. Das Siliziumkarbid wechselt von einem n-leitenden Zustand in einen semiisolierenden Zustand.

Bei dem Aufbau des Halbleitersubstrats aus einem den Elektroden benachbarten n-leitenden ersten Bereich und einem hierzu beabstandeten, semiisolierenden zweiten Bereich verbleibt unterhalb der Elektroden ein durch die Dicke des ersten Bereiches in der Tiefe beschränkter leitfähiger Bereich. Dieser leitfähige Bereich stellt im spannungsfreien Zustand den Stromkanal im Halbleitersubstrat zwischen den Graphen-Elektroden dar. Somit handelt es sich bei diesem Bauelement um ein sogenanntes "normally-on"-Bauelement. Durch Anlegen einer Spannung an eine Gate-Elektrode zwischen den Graphen-Elektroden sperrt das Bauelement. Grundsätzlich ist hierbei auch eine p-Dotierung des ersten Bereiches möglich.

Bei Ausgestaltung des Halbleiterbauelements mittels eines semiisolierenden Siliziumkarbid-Bereiches hat es sich weiter als vorteilhaft herausgestellt, wenn die Dicke des ersten, n-leitenden Bereiches des Siliziumkarbids eine vertikale Dicke zwischen 5 nm und 150 µm aufweist. Weiter bevorzugt beträgt die Dicke des ersten Bereiches zwischen 10 nm und 1 µm.

Somit wird ersichtlich, dass das angegebene Halbleiterbauelement auf Basis einer Graphen-Siliziumkarbid-Kombination einfach auch als ein "normally-off"-Bauelement herzustellen ist. Da die Silizium-Technologie "normally-off"-Transistoren einsetzt, bietet das hier beschriebene Bauelement somit gegenüber bisherigen Graphen-Bauelementen einen enormen Vorteil. Ohne Umbau von "Silizium-Schaltungen" könnten Silizium-Transistoren durch EG-FET-Transistoren (Epitaktische Graphen Feldeffekttransistoren) ausgetauscht werden.

Grundsätzlich ist es möglich, epitaktisches Graphen unabhängig von der Kristallorientierung auf einer Oberfläche des Siliziumkarbids zu erzeugen. Derzeit lässt sich die Qualität der durch Tempern des Siliziumkarbids erzeugten Lage epitaktischen Graphens verfahrenstechnisch am besten einstellen, wenn als hexagonale Oberfläche eine (0001)-Oberfläche des Siliziumkarbid-Kristalls als Ausgangsbasis eingesetzt ist. Bevorzugt werden hierbei für den Siliziumkarbid-Kristall 6H-, 4H- oder 3C-Polytypen eingesetzt. Dabei ist der 4H-Polytyp mittlerweile großtechnisch erhältlich. Der 6H-Polytyp des Siliziumkarbids ist ebenfalls kommerziell verfügbar.

Ausführungsbeispiele der Erfindung werden anhand einer Zeichnung näher erläutert. Dabei zeigen:
- Fig. 1A: schematisch einen Querschnitt durch ein Halbleiterbauelement gemäß einer ersten Ausführungsvariante,
- Fig. 1B: in einer Querschnittdarstellung den durchgeschalteten Zustand des Halbleiterbauelements gemäß Fig. 1A,
- Fig. 2A: in einem Querschnitt ein Halbleiterbauelement gemäß einer zweiten Ausführungsvariante,
- Fig. 2B: in einem Querschnitt den gesperrten Zustand des Halbleiterbauelements gemäß Fig. 2A,
- Fig. 3: schematisch in einem Querschnitt sowie in einer Aufsicht ein Halbleiterbauelement gemäß einer dritten Ausführungsvariante,
- Fig. 4A: eine Transferkennlinie des in Fig. 3 gezeigten Bauelements in logarithmischer und
- Fig. 4B: die Transferkennlinie des in Fig. 3 gezeigten Bauelements in linearer Darstellung.

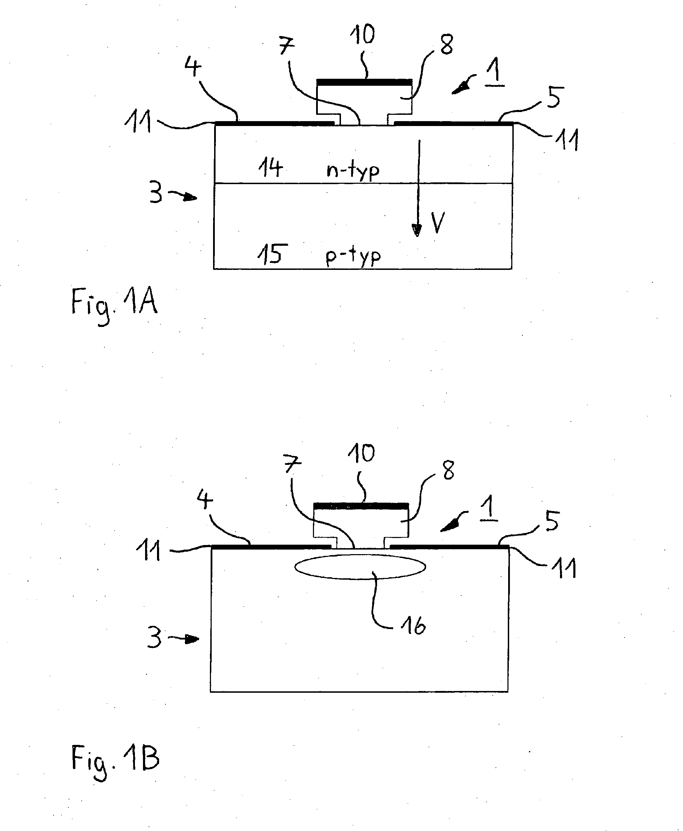

In Fig. 1A ist schematisch ein Querschnitt eines Halbleiterbauelements 1 gemäß einer ersten Ausführungsvariante dargestellt. Das Halbleiterbauelement 1 umfasst ein Halbleitersubstrat 3 aus Siliziumkarbid, auf dessen Oberfläche eine Source-Elektrode 4 und eine hiervon getrennte Drain-Elektrode 5 aufgebracht sind. In einem freigelegten Zwischenbereich 7 des Halbleitersubstrats 3 zwischen der Source-Elektrode 4 und der Drain-Elektrode 5 ist ein Gate-Stapel durch ein Dielektrikum 8 gebildet, auf dessen Oberseite eine Gate-Elektrode 10 angeordnet ist.

Die Source-Elektrode 4 und die Drain-Elektrode 5 umfassen wenigstens eine Monolage an epitaktischem Graphen 11, welches auf einer Oberfläche des Siliziumkarbid-Kristalls aufgewachsen ist. Beispielsweise handelt es sich bei der Oberfläche des Siliziumkarbids um eine (0001)-Oberfläche. Die wenigstens eine Monolage an epitaktischem Graphen 11 ist auf der Oberfläche des Siliziumkarbids durch thermisches Zersetzen des Siliziumkarbids erzeugt. Anschließend sind die beiden Elektroden 4, 5 dadurch hergestellt, dass die erzeugte Schicht an epitaktischem Graphen 11 im Zwischenbereich 7 unterbrochen wurde.

In vertikaler Richtung V weist das Halbleiterbauelement 1 ein Dotierprofil derart auf, dass das Siliziumkarbid in einem ersten Bereich 14, der den Elektroden 4, 5 benachbart ist, durch Dotierung mittels Stickstoff n-leitend ist. In einem zweiten Bereich 15, der den Elektroden 4, 5 abgewandt ist, ist das Siliziumkarbid durch Dotierung mittels Aluminium p-leitend.

Das Halbleitersubstrat kann beispielsweise durch epitaktisches Wachstum auf einem Siliziumkarbid-Wafer unter entsprechender Dotierung hergestellt werden. Das Unterbrechen der durch thermische Zersetzung des Siliziumkarbids entstandenen Graphen-Schicht 11 erfolgt beispielsweise mittels Lithographie und einer anschließenden Behandlung in einem Sauerstoffplasma.

Die wenigstens eine Monolage an epitaktischem Graphen 11 der Elektroden 4, 5 weist einen niedrigen, ohmschen Kontaktwiderstand zu dem Halbleitersubstrat auf. Die Materialkombination epitaktisches Graphen 11 auf n-dotiertem Siliziumkarbid zeigt eine niedrige Injektionsbarriere.

Die Dotierkonzentration im zweiten Bereich 15 des Halbleiterbereiches beträgt etwa 10¹⁸ Aluminiumatome pro cm³. Die vertikale Dicke des zweiten Bereiches ist unkritisch und beträgt beispielsweise einige µm. Im ersten Bereich 14 liegt die Dotierkonzentration an Stickstoffatomen bei etwa 10¹⁵ pro cm³. Die vertikale Dicke des ersten Bereiches 14 beträgt zwischen 1,5 und 2 µm.

Aufgrund der gewählten Dotierkonzentrationen und vertikalen Dicken der Schichten 14 und 15 erstreckt sich im spannungsfreien Zustand des in Fig. 1A dargestellten Halbleiterbauelements 1, die sich am n-p-Übergang ausbildende Raumladungszone oder Verarmungszone in den ersten Bereich 14 hinein bis zu den Elektroden 4, 5. Im Bereich des Halbleitersubstrats 3 unterhalb und zwischen den Elektroden 4, 5 liegt somit im spannungsfreien Zustand ein Bereich mit einer Verarmung an Ladungsträgern vor. Das Halbleiterbauelement 1 ist ein "normally-off"-Typ, wobei in einem spannungsfreien Zustand zwischen Source- und Drain-Elektrode kein Strom fließt. Das Bauelement 1 sperrt.

In Fig. 1B ist in demselben Querschnitt das Halbleiterbauelement 1 entsprechend Fig. 1A nochmalig dargestellt. In diesem Fall liegt jedoch an der Gate-Elektrode 10 eine positive Spannung an. Über das Dielektrikum 8 erfolgt im Halbleitersubstrat 3 unterhalb des Zwischenbereiches 7 eine Ladungsträgerinfluenzierung. Es entsteht ein leitfähiger Bereich 16 mit influenzierten Ladungsträgern. Dieser Bereich 16 bildet einen Stromkanal zwischen der Source-Elektrode 4 und der Drain-Elektrode 5. Das Halbleiterbauelement 1 schaltet durch. Es fließt ein Strom zwischen Source-Elektrode 4 und Drain-Elektrode 5 über einen Stromkanal innerhalb des Halbleitersubstrats 3.

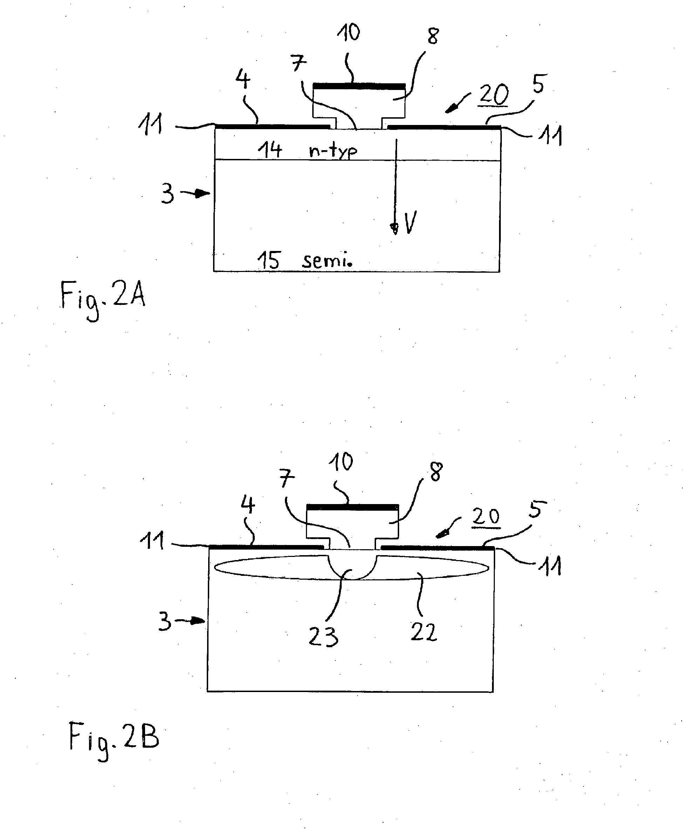

In Fig. 2A ist in einem Querschnitt ein Halbleiterbauelement 20 gemäß einer zweiten Ausführungsvariante dargestellt. Dabei bezeichnen gleiche Bezugszeichen gleiche Teile.

Entsprechend Fig. 1A umfasst auch das Halbleiterbauelement 20 gemäß Fig. 2A ein Halbleitersubstrat 3 aus Siliziumkarbid, auf dessen Oberfläche eine Source-Elektrode 4 und eine Drain-Elektrode 5 aufgebracht sind, die wenigstens eine Monolage an epitaktischem Graphen 11 auf der Siliziumkarbid-Oberfläche aufweisen. Die Elektroden 4, 5 des Halbleiterbauelements 20 entsprechend Fig. 2A sind ebenfalls mittels thermischer Zersetzung der Oberfläche des Siliziumkarbids hergestellt.

In einem Zwischenbereich 7 zwischen der Source-Elektrode 4 und der Drain-Elektrode 5 ist wiederum ein Gate-Stapel aus einem Dielektrikum 8 und einer darauf aufgebrachten Gate-Elektrode 10 angeordnet.

Wie Fig. 1A zeigt das Halbleitersubstrat 3 des Halbleiterbauelements 20 entsprechend Fig. 2A ein vertikales Dotierprofil. In einem ersten, den Elektroden 4, 5 benachbarten Bereich 14 ist das Siliziumkarbid durch Dotierung n-leitend. Im sich anschließenden zweite Bereich 15 hat das Siliziumkarbid durch eine Kompensationsdotierung jedoch semiisolierende Eigenschaften. Zur Dotierung des n-leitenden ersten Bereiches 14 ist Phosphor gewählt. Die Kompensationsdotierung des zweiten Bereiches 15 erfolgt beispielsweise durch Ionenimplantation von Vanadium. Im ersten Bereich 14 ist die Dotierkonzentration mit etwa 5 x 10¹⁷ Fremdatomen/cm³ gewählt. Die vertikale Dicke des ersten Bereichs 14 beträgt etwa 100 nm.

Im spannungsfreien Zustand ist durch die Dicke des n-leitenden ersten Bereiches 14 ein in der Tiefe begrenzter Stromkanal im Halbleitersubstrat 3 gegeben, durch den eine elektrisch leitende Verbindung zwischen der Source-Elektrode 4 und der Drain-Elektrode 5 gegeben ist. Das Halbleiterbauelement 20 entsprechend Fig. 2A ist somit ein Bauelement vom Typ "normally-on".

In Fig. 2B ist in einem Querschnitt das Halbleiterbauelement 20 gemäß Fig. 2A nochmals dargestellt. Allerdings ist nunmehr der Zustand des Halbleiterbauelements 20 gezeigt, wobei eine negative Spannung an die Gate-Elektrode 10 angelegt ist. Über das Dielektrikum 8 erfolgt eine Umladung im Zwischenbereich 7, so dass in der durch die n-Dotierung an sich gegebenen leitfähigen Schicht 22 ein Bereich 23 an verdrängten ladungsträgern erfolgt. Die Leitfähigkeit des Stromkanals im Halbleitersubstrat 3 zwischen der Source-Elektrode 4 und der Drain-Elektrode 5 wird reduziert. Das Halbleiterbauelement 20 sperrt bei Anliegen einer Gate-Spannung.

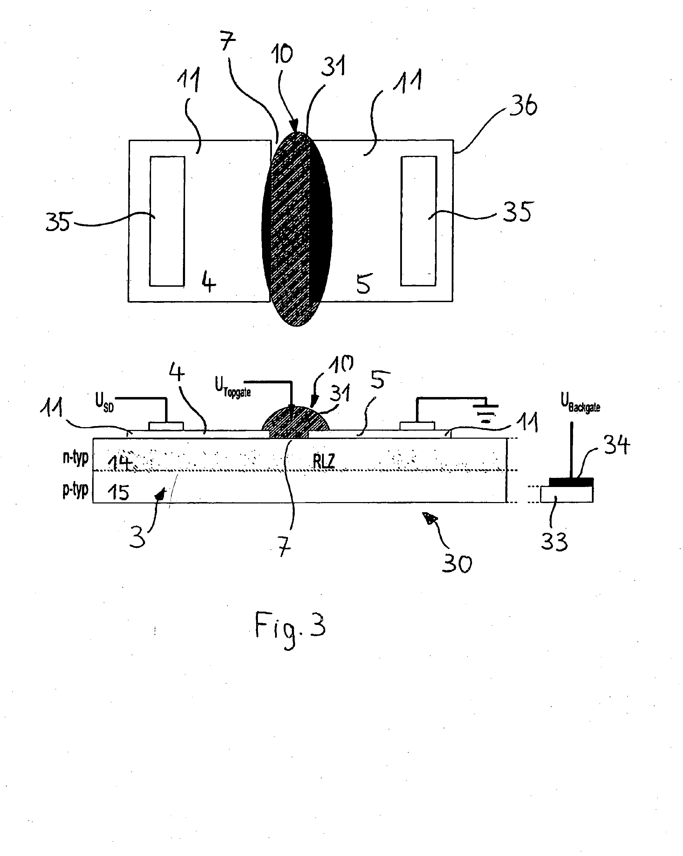

In Fig. 3 ist in einer Aufsicht und in einem Querschnitt ein Halbleiterbauelement 30 gemäß einer dritten Ausführungsvariante dargestellt. Dabei sind wiederum gleiche Teile mit gleichen Bezugszeichen versehen.

Bei dem Halbleiterbauelement 30 gemäß Fig. 3 weist das Halbleitersubstrat 3 unterhalb der Elektroden 4, 5 ebenfalls einen vertikalen n-p-Übergang auf. Es entsteht eine Raumladungszone RLZ, die sich bis weit in den ersten, n-leitenden Bereich 14 des Siliziumkarbids hinein erstreckt. Die Dotierkonzentrationen sowie die vertikalen Dicken der Bereiche 14, 15 können gegenüber dem in Fig. 1 dargestellten Halbleiterbauelement 1 variieren.

Im Unterschied zu dem in Fig. 1 dargestellten Halbleiterbauelement 1 ist in dem Zwischenbereich 7 zwischen der Source-Elektrode 4 und der Drain-Elektrode 5 kein Dielektrikum 8 aufgebracht. Vielmehr wird als eine Gate-Elektrode 10 eine elektrochemische Elektrode eingesetzt. Dazu ist ein Tropfen aus einer ionischen Flüssigkeit 31 zwischen den beiden Elektroden 4, 5 aufgebracht, in den zur elektrischen Kontaktierung eine Spitze eintaucht.

Weiter ist auf der Rückseite 33 des p-leitenden, zweiten Bereiches 15 des Halbleitersubstrats 3 eine Backgate-Elektrode 34 aufgebracht.

Zur Kontaktierung der wenigstens eine Monolage an epitaktischem Graphen 11 auf Siliziumkarbid umfassenden Elektroden 4, 5 sind elektrische Kontakte 35 aus Titan und Gold aufgebracht. Es können auch andere geeignete Metalle für die Kontakte eingesetzt sein.

Die Elektroden 4, 5 sind aus einer einzigen durch thermische Zersetzung des Siliziumkarbids entstehenden Graphen-Schicht 36 hergestellt. Dazu wurde die Schicht 36 im Zwischenbereich 7 mechanisch unterbrochen.

In der Querschnittsdarstellung entsprechend Fig. 3 sind die Anschlussspannungen bezeichnet. Dabei ist die Drain-Elektrode 5 mit Masse kontaktiert. An der Source-Elektrode 4 liegt die Source-Drain-Spannung U_{SD} an. An der Gate-Elektrode 10 ist die Gate-Spannung U_{Topgate} angelegt. Die an der Backgate-Elektrode 34 anliegende Spannung ist mit U_{Backgate} bezeichnet.

Das in Fig. 3 dargestellte Halbleiterbauelement 30 hat den großen Vorteil, dass es in operandi zwischen einem "normally-on"- und einem "normally-off"-Modus umgeschaltet werden kann. Dazu braucht lediglich die Spannung U_{Backgate} an der Backgate-Elektrode 34 entsprechend variiert zu werden. Wird eine entsprechende Spannung U_{Backgate} gewählt, so dass sich die Raumladungszone RLZ bis zu den Elektroden 4, 5 hin erstreckt, so liegt das Halbleiterbauelement 30 in einem "normally-off"-Zustand vor. Wird die Raumladungszone RLZ durch Änderung der Spannung U_{Backgate} in ihrer vertikalen Ausdehnung verkleinert, so wechselt das Halbleiterbauelement 30 in einen "normally-on"-Zustand.

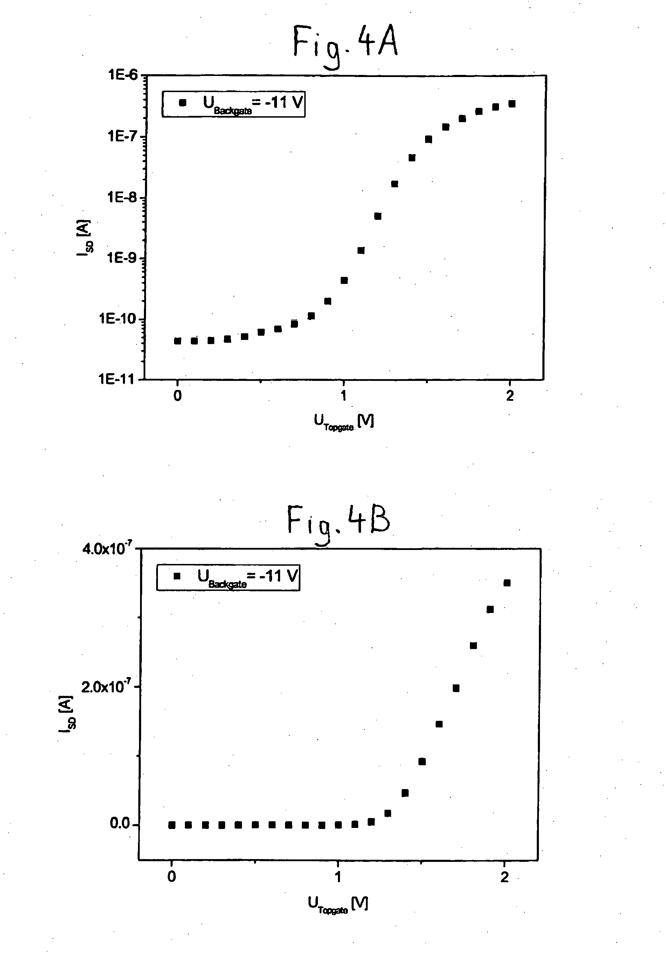

In den Fig. 4A und Fig. 4B ist das Schaltverhalten des Halbleiterbauelements 30 entsprechend Fig. 3 dargestellt.

Die entsprechende Transferkennlinie der Abhängigkeit des Stromes I_{SD} zwischen der Source-Elektrode 4 und der Drain-Elektrode 5 von der Gate-Spannung U_{Topgate} ist in Fig. 4A logarithmisch und in Fig. 4B linear dargestellt. Die Transferkennlinie ist dabei für eine Backgate-Spannung U_{Backgate} = -11 V, also für einen "normally-off"-Modus des in Fig. 3 gezeigten Bauelementes 30, aufgenommen. Die Schwellenspannung liegt bei 1,3 V. Der Source-Drain-Strom I_{SD} steigt linear bis zu einer Gate-Spannung U_{Topgate} von 2 V aufgrund der influenzierten Ladung an. Diese obere Grenze ist durch das elektrochemische Stabilitätsfenster der ionischen Flüssigkeit gegeben und wäre bei einem dielektrischen Gate-Stapel vermieden. Das on/off-Verhältnis der Ströme im eingeschalteten und gesperrten Zustand beträgt im verfügbaren Spannungsfenster etwa 10⁴.

Der in Fig. 3 gezeigte Aufbau ist für kleine Source-Drain-Spannungen realistisch. Bei Wahl eines Dielektrikums zur Aufnahme der Gate-Elektrode 10 und entsprechend variierter Geometrieparameter ist eine hohe Spannungsfestigkeit bis zu etwa 1 kV zu erwarten.

### Bezugszeichenliste

- 1: Halbleiterbauelement
- 3: Halbleitersubstrat (Siliziumkarbid)
- 4: Source-Elektrode
- 5: Drain-Elektrode
- 7: Zwischenbereich
- 8: Dielektrikum
- 10: Gate-Elektrode
- 11: epitaktisches Graphen
- 14: erster Bereich
- 15: zweiter Bereich
- 16: influenzierte Ladungsträger
- 20: Halbleiterbauelement
- 22: leitfähige Schicht
- 23: verdrängte Ladungsträger

- 31: ionische Flüssigkeit
- 33: Rückseite
- 34: Backgate-Elektrode
- 35: Kontakt
- 36: Schicht

- V: Vertikalrichtung
- RLZ: Raumladungszone

## Patentansprüche

1. Halbleiterbauelement (1, 20, 30) mit einem Halbleitersubstrat (3) aus Siliziumkarbid und mit darauf aufgebrachten, getrennten Elektroden (4, 5), die jeweils wenigstens eine Monolage epitaktisches Graphen (11) auf Siliziumkarbid umfassen, derart dass ein Stromkanal zwischen den Elektroden (4, 5) durch das Halbleitersubstrat (3) gebildet ist.

2. Halbleiterbauelement (1, 20, 30) nach Anspruch 1,
wobei die getrennten Elektroden (4, 5) durch eine, wenigstens die eine Monolage epitaktisches Graphen (11) umfassende Schicht gebildet sind, die zwischen den Elektroden (4, 5) unterbrochen ist.

3. Halbleiterbauelement (1, 20, 30) nach Anspruch 1 oder 2,
wobei als Elektroden (4, 5) auf dem Halbleitersubstrat (3) eine Source-Elektrode (4) und eine hiervon getrennte Drain-Elektrode (5) aufgebracht sind, und wobei zwischen der Source-Elektrode (4) und der Drain-Elektrode (5) eine elektrisch isolierte Gate-Elektrode (10) angeordnet ist.

4. Halbleiterbauelement (1, 20, 30) nach Anspruch 3,
wobei die Gate-Elektrode (10) unter Zwischenlage eines Dielektrikums (8) auf dem Halbleitersubstrat (3) angeordnet ist.

5. Halbleiterbauelement (1, 20, 30) nach Anspruch 1 oder 2,
wobei als Elektroden (4, 5) auf dem Halbleitersubstrat (3) eine Source-Elektrode (4) und eine hiervon getrennte Drain-Elektrode (5) aufgebracht sind, und wobei zwischen der Source-Elektrode (4) und der Drain-Elektrode (5) als eine Gate-Elektrode (10) eine ionische Flüssigkeit (31) auf dem Halbleitersubstrat (3) aufgebracht ist.

6. Halbleiterbauelement (1, 20, 30) nach einem der vorhergehenden Ansprüche,
wobei das Halbleitersubstrat (3) ein vertikales Dotierprofil aufweist.

7. Halbleiterbauelement (1, 20, 30) nach Anspruch 6,
wobei das Halbleitersubstrat (3) eine im Wesentlichen parallel zu den Elektroden (4, 5) verlaufende Dotierungsgrenze zwischen einem den Elektroden (4, 5) zugewandten ersten Bereich (14) und einem den Elektroden (4, 5) abgewandten zweiten Bereich (15) umfasst, und wobei das Siliziumkarbid im ersten Bereich (14) eine vom zweiten Bereich verschiedene Dotierung aufweist.

8. Halbleiterbauelement (1, 20, 30) nach Anspruch 7,
wobei das Siliziumkarbid im ersten Bereich (14) des Halbleitersubstrats (3) n-dotiert und im zweiten Bereich (15) des Halbleitersubstrats p-dotiert ist.

9. Halbleiterbauelement (1, 20, 30) nach Anspruch 8,
wobei die Dotierkonzentration und die vertikale Dicke des ersten Bereichs (14) derart gewählt sind, dass sich eine am n-p-Übergang entlang der Dotiergrenze ausbildende Verarmungszone gegebenenfalls mittels einer äußeren elektrischen Spannung in den ersten Bereich (14) hinein bis zur
Oberfläche des Halbleitersubstrats (3) erstreckt.

10. Halbleiterbauelement (1, 20, 30) nach einem der Ansprüche 8 bis 9, wobei die Dotierkonzentration im ersten Bereich (14) kleiner gewählt ist als im zweiten Bereich (15).

11. Halbleiterbauelement (1, 20, 30) nach einem der Ansprüche 7 bis 10, wobei zusätzlich eine Backgate-Elektrode (34) umfasst ist, die elektrisch leitend mit dem zweiten Bereich (15) verbunden ist.

12. Halbleiterbauelement (1, 20, 30) nach Anspruch 7,
wobei das Siliziumkarbid im ersten Bereich (14) des Halbleitersubstrats (3) n-dotiert und im zweiten Bereich (15) des Halbleitersubstrats (3) semiisolierend ist.

13. Halbleiterbauelement (1, 20, 30) nach Anspruch 12,
wobei das semiisolierende Siliziumkarbid mit Vanadium dotiert ist.

14. Halbleiterbauelement (1, 20, 30) nach Anspruch 12 oder 13,
wobei der erste Bereich (14) eine vertikale Dicke zwischen 5 nm und 150 µm aufweist.

15. Halbleiterbauelement (1, 20, 30) nach einem der vorhergehenden Ansprüche,
wobei das Siliziumkarbid ein Einkristall ist, und wobei das epitaktische Graphen (11) der Elektroden (4, 5) auf der (0001)-Oberfläche des Siliziumkarbid-Einkristalls aufgebracht ist.

## Claims

1. A semiconductor component (1, 20, 30) having a semiconductor substrate (3) comprising silicon carbide and having separate electrodes (4, 5) applied thereto, said electrodes each comprising at least one monolayer of epitaxial graphene (11) on silicon carbide, in such a way that a current channel is formed between the electrodes (4, 5) through the semiconductor substrate (3).

2. The semiconductor component (1, 20, 30) as claimed in claim 1,
wherein the separate electrodes (4, 5) are formed by a layer which comprises at least the one monolayer of epitaxial graphene (11) and which is interrupted between the electrodes (4, 5).

3. The semiconductor component (1, 20, 30) as claimed in claim 1 or 2,
wherein a source electrode (4) and a drain electrode (5) separate therefrom are applied as electrodes (4, 5) on the semiconductor substrate (3), and wherein an electrically insulated gate electrode (10) is arranged between the source electrode (4) and the drain electrode (5).

4. The semiconductor component (1, 20, 30) as claimed in claim 3,
wherein the gate electrode (10) is arranged on the semiconductor substrate (3) with the interposition of a dielectric (8).

5. The semiconductor component (1, 20, 30) as claimed in claim 1 or 2,
wherein a source electrode (4) and a drain electrode (5) separate therefrom are applied as electrodes (4, 5) on the semiconductor substrate (3), and wherein an ionic liquid (31) on the semiconductor substrate (3) is applied as a gate electrode (10) between the source electrode (4) and the drain electrode (5).

6. The semiconductor component (1, 20, 30) as claimed in one of the preceding claims,
wherein the semiconductor substrate (3) has a vertical doping profile.

7. The semiconductor component (1, 20, 30) as claimed in claim 6,
wherein the semiconductor substrate (3) comprises a doping boundary between a first region (14) facing the electrodes (4, 5) and a second region (15) facing away from the electrodes (4, 5), said doping boundary running substantially parallel to the electrodes (4, 5), and wherein the silicon carbide in the first region (14) has a different doping than the second region.

8. The semiconductor component (1, 20, 30) as claimed in claim 7,
wherein the silicon carbide is n-doped in the first region (14) of the semiconductor substrate (3) and p-doped in the second region (15) of the semiconductor substrate.

9. The semiconductor component (1, 20, 30) as claimed in claim 8,
wherein the doping concentration and the vertical thickness of the first region (14) are chosen in such a way that a depletion zone that forms at the n-p junction along the doping boundary extends if appropriate by means of an external electrical voltage into the first region (14) as far as the surface of the semiconductor substrate (3).

10. The semiconductor component (1, 20, 30) as claimed in one of the claims 8 to 9,
wherein the doping concentration is chosen to be smaller in the first region (14) than in the second region (15).

11. The semiconductor component (1, 20, 30) as claimed in one of the claims 7 to 10,
wherein a back gate electrode (34) is additionally comprised, which is electrically conductively connected to the second region (15).

12. The semiconductor component (1, 20, 30) as claimed in claim 7,
wherein the silicon carbide is n-doped in the first region (14) of the semiconductor substrate (3) and semi-insulating in the second region (15) of the semiconductor substrate (3).

13. The semiconductor component (1, 20, 30) as claimed in claim 12,
wherein the semi-insulating silicon carbide is doped with vanadium.

14. The semiconductor component (1, 20, 30) as claimed in claim 12 or 13, wherein the first region (14) has a vertical thickness of between 5 nm and 150 µm.

15. The semiconductor component (1, 20, 30) as claimed in one of the preceding claims,
wherein the silicon carbide is a single crystal, and wherein the epitaxial graphene (11) of the electrodes (4, 5) is applied on the (0001) surface of the silicon carbide single crystal.

## Revendications

1. Composant semi-conducteur (1, 20, 30) avec un substrat semi-conducteur (3) constitué de carbure de silicium et avec des électrodes (4, 5) séparées appliquées sur celui-ci, lesquelles comprennent chacune au moins une monocouche de graphène épitaxié (11) sur du carbure de silicium, de sorte qu'un canal d'écoulement entre les électrodes (4, 5) est formé à travers le substrat semi-conducteur (3).

2. Composant semi-conducteur (1, 20, 30) selon la revendication 1,
les électrodes séparées (4, 5) étant formées par une couche comprenant au moins la une monocouche de graphène épitaxié (11), laquelle est interrompue entre les électrodes (4, 5).

3. Composant semi-conducteur (1, 20, 30) selon la revendication 1 ou 2,
une électrode de source (4) et une électrode de drain (5) séparée de celle-ci étant appliquées comme électrodes (4, 5) sur le substrat semi-conducteur (3), et une électrode de grille (10) électriquement isolée étant disposée entre l'électrode de source (4) et l'électrode de drain (5).

4. Composant semi-conducteur (1, 20, 30) selon la revendication 3,
l'électrode de grille (10) étant disposée avec une couche intermédiaire d'un diélectrique (8) sur le substrat semi-conducteur (3).

5. Composant semi-conducteur (1, 20, 30) selon la revendication 1 ou 2,
une électrode de source (4) et une électrode de drain séparée de celle-ci (5) étant appliquées comme électrodes (4, 5) sur le substrat semi-conducteur (3), et un liquide ionique (31) étant appliqué entre l'électrode de source (4) et l'électrode de drain (5) comme une électrode de grille (10) sur le substrat semi-conducteur (3).

6. Composant semi-conducteur (1, 20, 30) selon l'une des revendications précédentes,
le substrat semi-conducteur (3) présentant un profil de dopage vertical.

7. Composant semi-conducteur (1, 20, 30) selon la revendication 6,
le substrat semi-conducteur (3) comprenant une limite de dopage s'écoulant de manière essentiellement parallèle par rapport aux électrodes (4, 5) entre un premier domaine (14) adjacent aux électrodes (4, 5) et un second domaine (15) éloigné des électrodes (4, 5), et le carbure de silicium présentant dans un premier domaine (14) un dopage différent du second domaine.

8. Composant semi-conducteur (1, 20, 30) selon la revendication 7,
le carbure de silicium étant n-dopé dans un premier domaine (14) du substrat semi-conducteur (3) et étant p-dopé dans un second domaine (15) du substrat semi-conducteur.

9. Composant semi-conducteur (1, 20, 30) selon la revendication 8,
la concentration de dopage et l'épaisseur verticale du premier domaine (14) étant choisies de sorte qu'une zone d'appauvrissement formée à la transition n-p le long de la limite de dopage s'étend éventuellement au moyen d'une tension électrique externe à l'intérieur dans le premier domaine (14) jusqu'à une surface du substrat semi-conducteur (3).

10. Composant semi-conducteur (1, 20, 30) selon l'une quelconque des revendications 8 à 9,
la concentration de dopage étant choisie dans un premier domaine (14) plus faible que dans un second domaine (15).

11. Composant semi-conducteur (1, 20, 30) selon l'une quelconque des revendications 7 à 10,
une électrode de grille arrière (34) étant de plus comprise, laquelle est liée de manière électroconductrice avec le second domaine (15).

12. Composant semi-conducteur (1, 20, 30) selon la revendication 7,
le carbure de silicium étant n-dopé dans un premier domaine (14) du substrat semi-conducteur (3) et étant semi-isolant dans un second domaine (15) du substrat semi-conducteur (3).

13. Composant semi-conducteur (1, 20, 30) selon la revendication 12,
le carbure de silicium semi-isolant étant dopé avec du vanadium.

14. Composant semi-conducteur (1, 20, 30) selon la revendication 12 ou 13,
le premier domaine (14) présentant une épaisseur verticale de 5 nm à 150 µm.

15. Composant semi-conducteur (1, 20, 30) selon l'une quelconque des revendications précédentes,
le carbure de silicium étant un monocristal, et le graphène épitaxié (11) des électrodes (4, 5) étant appliqué sur la surface (0001) du monocristal de carbure de silicium.
